# DEMANDE DE BREVET EUROPEEN

(11) **EP 0 668 612 A1**
(43) Date de publication de la demande: **23.08.1995**
(21) Numéro de dépôt: 95400321.6
(22) Date de dépôt: 15.02.1995
(51) Int. Cl.: H01L 21/60

(54) **Dispositif de chauffage pour la réalisation de connexions par un matériau fusible**

(30) Priorité: 17.02.1994 FR 9401818
(71) Demandeur: COMMISSARIAT A L'ENERGIE ATOMIQUE, 75015 Paris Cédex (FR)
(72) Inventeur: Massit, Claude, F-38330 Saint-Ismier (FR); Nicolas, Gérard, F-38340 Voreppe (FR); Parat, Guy, F-38130 Echirolles (FR)
(74) Mandataire: Dubois-Chabert, Guy

(57) **Abrégé**

Dispositif de chauffage pour la réalisation de connexion par un matériau fusible.

Ce dispositif de chauffage pour connecter, par l'intermédiaire d'un matériau fusible, sur un support de connexion (112), au moins un composant (118) reporté sur le support dans au moins une région de connexion (114) à la périphérie du support, se caractérise en ce que le dispositif comporte des moyens de chauffage localisé du support (112) et/ou du composant (118) dans la région de connexion.

Application à la fabrication d'écrans plats d'affichage.

## Description

### Domaine technique

La présente invention concerne un dispositif de chauffage pour la réalisation de connexions électriques et/ou mécaniques entre un ou plusieurs composants à connecter et un support de connexion, par l'intermédiaire d'un matériau fusible.

On entend par composant à connecter aussi bien un composant électronique tel qu'une puce électronique, un circuit ou une partie de circuit électronique qu'un composant mécanique tel qu'un capot ou un capteur de grandeurs physiques.

Le dispositif est en particulier adapté à la mise en oeuvre d'un procédé de connexion par microbilles connu sous la désignation de "flip-chip".

Il s'applique notamment dans le domaine de l'électronique intégrée, par exemple, dans la fabrication d'écrans plats d'affichage appelés en terminologie anglo-saxonne "Flat panel display" tels que par exemple les écrans à cristaux liquides, les écrans fluorescents à micropointes et les écrans à plasma. En effet, lors de la fabrication de ces écrans, des puces électroniques doivent être connectées à l'écran, cette connexion se fait avantageusement par des techniques dites de report.

### Etat de la technique antérieure

On connaît différentes techniques de report de circuits et de puces électroniques. Dans le domaine, par exemple, de la réalisation d'écrans plats on distingue notamment les techniques dites COB (Chip on bord), COF (chip on flex) et COG (chip on glass).

Ces techniques de report servent en particulier à reporter sur des écrans plats, en bordure de ces derniers, des composants électroniques de commande de l'affichage de points d'image ou pixels de l'écran.

Pour des raisons de simplification des connexions et dans une perspective de plus grande intégration, la technique de COG s'avère la plus avantageuse pour les écrans plats.

Dans la technique de COG qui est un report de composants sur une structure de verre on distingue encore plusieurs variantes.

Parmi ces variantes, on peut citer la technique dite COG-collé qui consiste pour l'essentiel en un report de puces électroniques grâce à un élastomère. Bien que d'un coût relativement faible, cette variante présente des problèmes liés au montage individuel des puces, au rendement de report et aux mauvaises résistances de contact et des problèmes de fiabilité en atmosphère humide. Le remplacement d'une puce est par ailleurs quasi impossible.

Une autre variante dite COG par thermocompression présente outre les problèmes de montage individuel des puces et de rendement de report, des problèmes liés aux pressions nécessaires au montage des puces, qui peuvent engendrer des microfissures dans les circuits intégrés.

Cette méthode implique par ailleurs l'usage de bossages de connexion de faible épaisseur qui limitent ainsi la tenue mécanique des puces, notamment lorsque les matériaux constituant les puces et celui du support de connexion présentent des coefficients de dilatation thermique différents.

Une autre variante encore est connue sous la désignation COG par câblage filaire (wire bonding).

Selon cette variante des plots de connexion du composant à connecter et des plots du support de connexion sont reliés au moyen de fils. Comme chaque fil doit être soudé sur deux plots, cette technique pose des problèmes de rendement pour des systèmes multi-puces à grand nombre de contacts, et des problèmes d'encapsulation des puces très rapprochées. De plus, le remplacement éventuel d'une puce défectueuse s'avère particulièrement délicat.

Finalement pour répondre à l'augmentation du nombre et de la complexité des composants ou des circuits intégrés, ainsi que de leur fréquence de fonctionnement, une quatrième variante de réalisation du report sur verre COG est celle connue sous la désignation SCOG (Solderable Chip On Glass). Elle utilise la technologie "Flip Chip" de refusion de bossages en matériau fusible.

Les documents (1), (2), (3) et (4) référencés en fin de la description, illustrent ces différentes variantes de report de puces.

Si la technique de flip-chip apparaît comme particulièrement intéressante pour le montage de puces sur des écrans plats, comme évoqué ci-dessus, son utilisation ne se limite pas au report des puces sur verre, mais peut concerner également le montage d'une puce dans un boîtier, le montage de puces sur des modules multipuces ou encore sur divers capteurs par exemple.

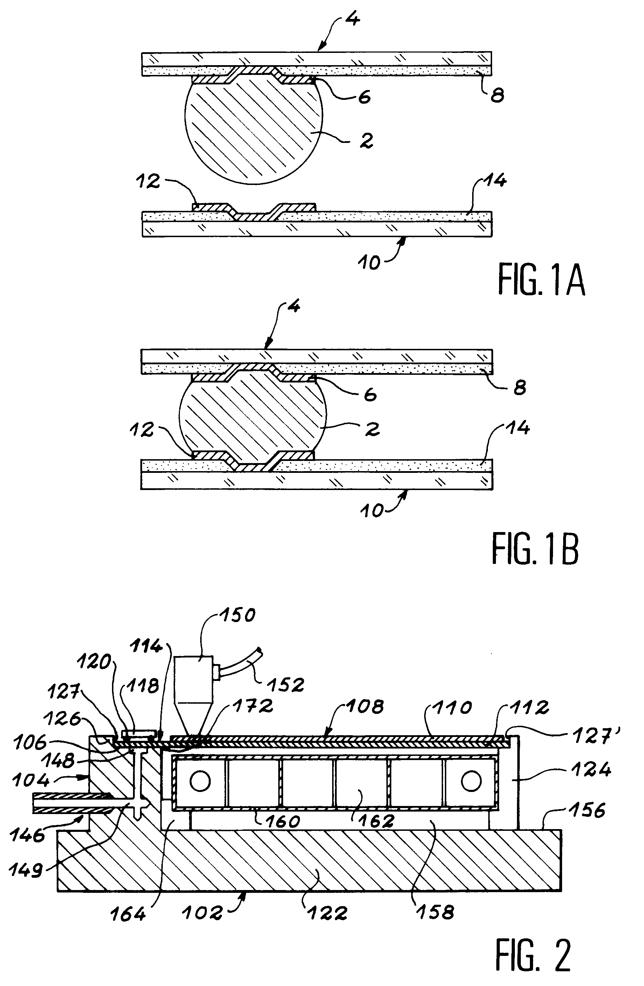

Un exemple de flip-chip est illustré de manière schématique avec les figures 1A et 1B.

Comme le montre la figure 1A, cette technique consiste dans un premier temps à déposer des billes 2 en un métal ou un alliage fusible sur une première structure à connecter 4, sur des plots conducteurs électriques 6 en un matériau mouillable par le matériau de la bille, et entourés par une plage 8 de matériau non mouillable et isolant électrique.

Pour des raisons de simplification, une seule bille 2 est représentée à la figure 1. La structure 4, munie des billes 2 est reportée sur un support de connexion 10 présentant également des plots conducteurs 12 en un matériau mouillable, entourés par une plage 14 de matériau isolant non mouillable, et destinés à recevoir les billes 2.

L'ensemble de la structure 4, munie de billes, et du support 10, sont portés à une température supérieure à la température de fusion du métal des billes 2. Ce chauffage permet de braser ainsi les plots 6 sur les plots 12 par l'intermédiaire des billes, comme le montre la figure 1B.

Le support 10 peut être par exemple un boîtier, un substrat de circuits intégrés, un capteur ou un écran plat. De même, la structure 4 peut être une puce électronique, un capot ou un autre substrat de circuit intégré. Les billes 2 peuvent être par ailleurs remplacées par des disques de matériau fusible ayant la même fonction et peuvent être disposées avant brasage, aussi bien sur les plots 6 que les plots 12.

Le chauffage de l'ensemble du support 10 et de la structure 4 peut avoir lieu soit par convection, par exemple par un flux d'air chaud ou dans un four à passage, soit par conduction, par exemple au moyen d'une plaque chauffante appliquée sur le support 10, soit encore par rayonnement.

Toutes ces solutions entraînent en général un chauffage de l'ensemble des pièces (support de connexion 10 et structure 4) à une température supérieure à la température de fusion du métal ou de l'alliage de la bille.

Or, cette température peut être incompatible avec certains organes des pièces à interconnecter.

En particulier, lorsque le support de connexion fait partie d'un écran plat à cristal liquide, la température de fusion des billes est excessive.

A titre d'exemple, si le métal fusible des billes est de l'indium, il faut chauffer les pièces à une température de l'ordre de 180°C qui est incompatible avec la température maximale supportée par la cellule à cristal liquide, qui est de l'ordre de 100°C.

Aussi, un objectif de l'invention est-il notamment de fournir un dispositif de chauffage permettant le brasage des puces ou des structures à connecter sur des supports de connexion, tout en étant compatible avec les températures maximales supportables par les structures utilisant lesdits supports tels que par exemple des écrans plats d'affichage.

### Exposé de l'invention

L'invention se rapporte plus précisément à un dispositif de chauffage pour connecter, par l'intermédiaire d'un matériau fusible, sur un support de connexion, au moins un composant reporté sur le support dans au moins une région de connexion à la périphérie du support, caractérisé en ce que le dispositif comporte des moyens de chauffage localisé du support et/ou du composant dans la région de connexion, les moyens de chauffage comportant une plaque de chauffage présentant au moins une plage de transmission de chaleur par conduction au support de connexion dans la région de connexion, la plage de transmission étant ménagée sur une partie saillante de la plaque, faisant saillie sur une partie sensiblement plane, tournée vers le support de connexion, de manière à préserver une couche d'air de protection thermique entre la partie sensiblement plane de la plaque et le support, en dehors de la région de connexion.

Grâce au dispositif de l'invention, il est possible de n'échauffer les pièces à connecter que dans la région de connexion en maintenant le support hors région de connexion, à une température plus faible et telle qu'elle n'altère pas d'éventuels organes associés au support et sensibles à la chaleur. Par ailleurs, il est possible de chauffer simultanément toutes les pièces à connecter, ce qui permet avantageusement de réaliser toutes les connexions dans la même opération.

La couche d'air préservée entre la partie de la plaque de chauffage tournée vers le support de connexion et le support de connexion constitue de par sa résistance thermique élevée une isolation de la partie du support de connexion qui n'est pas en contact avec la plage de transmission de chaleur.

Pour protéger encore davantage les organes sensibles à la chaleur des pièces à interconnecter, un écran thermique en un matériau tel que du verre ou de la céramique peut être disposé dans la couche d'air entre la plaque de chauffage et le support de connexion.

Afin d'améliorer la protection thermique fournie par l'écran, celui-ci peut, selon un aspect avantageux de l'invention, comporter une canalisation intérieure de circulation d'un fluide de refroidissement tel que, par exemple, de l'air ou de l'eau.

Selon un mode de réalisation avantageux, le dispositif peut comporter en outre des moyens de maintien du support de connexion pour assurer un contact plan entre ledit support et la plage de transmission, tels que des cales reposant sur la partie de la plaque tournée vers le substrat.

Le dispositif comprend en outre des moyens de positionnement du support sur la plage de transmission tels que des surfaces d'appui 127 disposées perpendiculairement à la plage de transmission et ménagées dans la partie supérieure de la partie saillante de la plaque et/ou des cales ou tels que des moyens de fixation du support sur la plaque.

Afin d'améliorer le contact thermique entre la plage de transmission et le support, le dispositif peut être équipé d'un système d'aspiration qui débouche dans la plage de transmission de chaleur.

Le dispositif de l'invention peut être réalisé en mettant en oeuvre différents moyens de transmission de chaleur aux pièces à interconnecter. La chaleur peut être transmise par conduction, comme décrit ci-dessus, mais aussi par rayonnement, ou éventuellement par convection, ou par combinaison de deux, voire des trois moyens de transmission de la chaleur.

Ainsi, selon une variante de l'invention, les moyens de chauffage peuvent comporter au moins une source de rayonnement. Par ailleurs, le dispositif peut comporter en fonction du type de source utilisée, un écran thermique disposé entre la source de rayonnement et le support de connexion.

L'écran thermique comporte une plaque de protection disposée entre la source et le support. Une fenêtre de passage du rayonnement est alors pratiquée dans la plaque en face de la région de connexion.

Avantageusement, la plaque présente sur une face tournée vers la source, une surface réfléchissante.

La source de rayonnement peut être dirigée dans la région de connexion, soit vers le support de connexion, soit vers le ou les composants à connecter, soit encore vers chacune de ces parties. En outre, il est possible de combiner un chauffage par conduction tel que décrit précédemment et le chauffage par rayonnement.

De façon générale, que la source de rayonnement soit une lampe à infrarouge ou un dispositif laser par exemple, elle est agencée de manière à échauffer le mieux possible et le plus sélectivement possible la région de connexion pour faire fondre le matériau fusible des billes de connexion. Dans le cas d'une source de rayonnement laser, la plaque de protection n'est pas nécessaire.

Dans le cas où le support de connexion est une paroi d'une structure particulièrement sensible à la chaleur tel que, par exemple, un écran plat (cellule à cristal liquide par exemple) et lorsque la transmission de chaleur par le support lui-même risque d'endommager la structure sensible, il est possible, conformément à l'invention, d'appliquer à proximité ou de préférence sur la structure sensible à la chaleur un ou plusieurs doigts caloporteurs de refroidissement.

Ces doigts peuvent comporter ou non un fluide de refroidissement et peuvent être éventuellement cumulés avec les autres moyens de protection thermique évoqués.

D'autres caractéristiques et avantages de l'invention ressortiront mieux de la description qui va suivre, donnée à titre illustratif et non limitatif, en référence aux figures annexées.

### Brève description des figures

- les figures 1A et 1B, déjà décrites, sont des vues schématiques partielles et à grande échelle illustrant une interconnexion par bille de matériau fusible
- la figure 2 est une coupe d'un dispositif selon l'invention et selon une première variante.
- la figure 3 est une coupe transversale d'un écran thermique du dispositif selon l'invention.
- la figure 4 est une vue simplifiée de dessus de la première variante du dispositif selon l'invention.
- la figure 5 est une coupe d'un dispositif selon l'invention selon une deuxième variante de l'invention.
- la figure 6 est une représentation schématique d'un mode de chauffage de puces électroniques selon l'invention.
- la figure 7 est une coupe d'un dispositif cumulant les caractéristiques de la première et de la seconde variante de l'invention.
- la figure 8 est une coupe d'un écran d'affichage équipé de doigts de refroidissement conformément à un aspect de l'invention.

### Exposé détaillé de modes de réalisation

Le dispositif illustré à la figure 2 comporte une plaque de chauffage 102 avec une partie saillante 104 présentant une plage de transmission de chaleur 106. La plaque peut soit comporter une source de chaleur interne telle que par exemple une résistance chauffante électrique non représentée, soit être en contact avec une source de chaleur. La plaque de chauffage 102 est réalisée préférentiellement en un matériau bon conducteur de la chaleur. Un métal tel que le cuivre ou le laiton peut convenir.

Un écran 108 plat d'affichage par exemple à cristal liquide 110 comprend une première et une deuxième parois telles que des lames de verre. La première paroi constitue un substrat de support de connexion 112, disposé sur la plaque de chauffage.

Une partie du substrat 112 désignée par région de connexion 114 est en appui contre la plage de transmission de chaleur 106 ménagée sur la partie 104.

La plage 106 transmet vers la région de connexion, dans laquelle est effectué le report de composants 118, la chaleur nécessaire à la fusion du matériau de billes ou disques de connexion 120. Selon le cas, la plaque 102 peut comporter une ou plusieurs parties saillantes 104 avec une ou plusieurs plages 106.

Sur la figure 2, le composant 118 figure une puce électronique comprenant des circuits de commande de l'écran d'affichage 108.

L'écran 108 est maintenu sensiblement parallèle à une partie horizontale et plane 122 de la plaque de chauffage sur laquelle la partie 104 fait saillie, à l'aide d'une ou de plusieurs cales 124. Afin de positionner correctement l'écran, selon un mode particulier de réalisation, une surface d'appui 127 d'une bordure 126 disposée perpendiculairement à la plage 106 ainsi qu'une encoche 127' sur la cale 124 sont prévues.

Pour parfaire l'application de la région de connexion 114 du support de connexion sur la plage de transmission de chaleur 106 et de réduire la résistance thermique de contact entre ces parties, un dispositif d'aspiration 146 est prévu dans la partie 104. Le dispositif 146 comporte une tranchée d'aspiration 148 débouchant de préférence aux extrémités sur la plage 106 qui est alors rainurée en regard de la région de connexion. La tranchée d'aspiration 148 est reliée à un aspirateur, non représenté, par une canalisation 149 pratiquée dans la saillie 104.

Un ou plusieurs "doigts froids" de refroidissement 150 peuvent être mis par ailleurs en contact avec l'écran au voisinage de la région de connexion. Ils permettent de refroidir l'écran 108 en dehors de la zone de connexion et évitent la transmission de chaleur par conduction dans l'écran 108. Le doigt 150, tel que représenté, comporte préférentiellement une canalisation 152 de circulation d'un gaz ou d'un liquide de refroidissement.

Entre la face 156 de la partie 122, tournée vers l'écran 108 et le support 112 se trouve une couche d'air 158 qui constitue un écran thermique. La résistance thermique élevée de la couche d'air est mise à profit pour former une isolation de l'écran 108.

Pour augmenter l'efficacité de la protection thermique, un écran thermique 160 selon une variante, est disposé dans la couche d'air 158. L'écran thermique 160 comporte avantageusement une canalisation intérieure 162 pour faire circuler de l'air ou de l'eau par exemple afin de le refroidir. L'écran thermique 160 est également maintenu et positionné par des cales 124, 164.

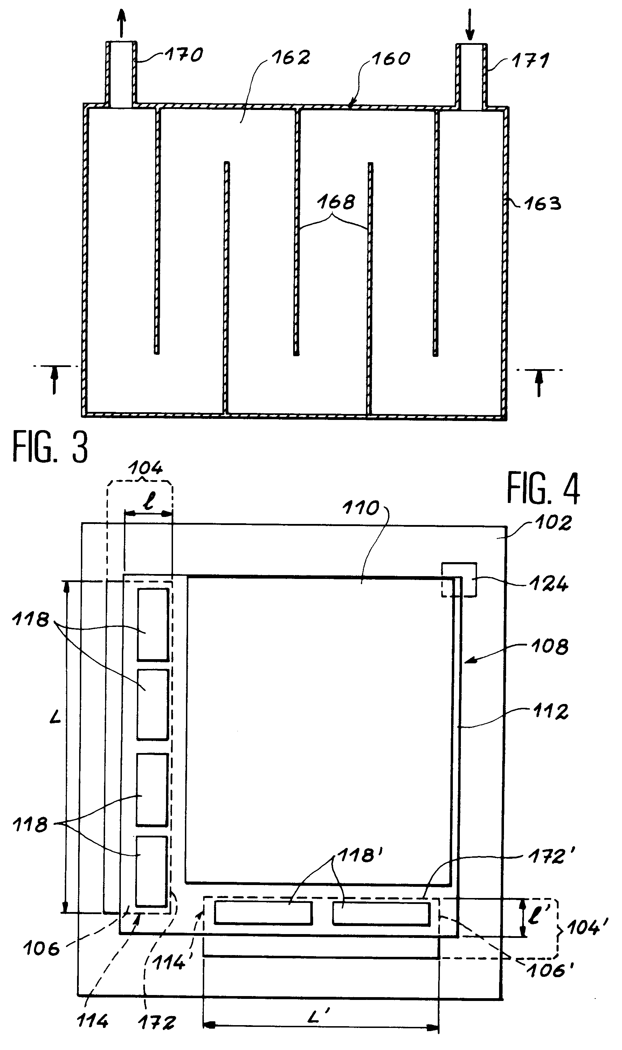

La figure 3, qui est une coupe transversale de l'écran 160, montre plus en détail la structure de l'écran "thermique" 160.

L'écran thermique 160 comporte une paroi extérieure 163 et présente des chicanes intérieures 168 pour augmenter la longueur du parcours de la canalisation 162.

(Les chicanes sont par exemple des cloisons partiellement ouvertes, reliées à la paroi 163).

Des embouchures d'entrée 170 et de sortie 171 permettent de relier la canalisation 162 par exemple à un réseau de distribution d'eau afin de refroidir l'écran 160.

L'écran thermique 160 n'est toutefois pas indispensable au fonctionnement du dispositif. A titre d'exemple, le tableau 1 donne des mesures d'échauffement pour le dispositif où seule la couche d'air 158 est prévue comme écran thermique. Les mesures sont effectuées avec une lame de verre 112 d'une épaisseur de 1,1 mm et pour des épaisseurs e de la couche d'air 158 croissantes, la plaque de chauffage étant régulée à 200°C.

**TABLEAU**

| **EPAISSEUR e EN mm** | **TEMPERATURE INITIALE** | **TEMPERATURE MAXIMALE AU CENTRE DE L'ECRAN D'AFFICHAGE 108** | **TEMPS MIS POUR ATTEINDRE LA TEMPERATURE MAXIMALE** |
|---|---|---|---|
| 0 | 20°C | 190°C | 30 s |
| 1 | 20°C | 135°C | 3 min. |
| 3 | 20°C | 110°C | 4 min. |
| 5 | 20°C | 100°C | 6 min. |

Il apparaît d'après le tableau ci-dessus qu'une épaisseur d'air de 5 mm entraîne une température maximale au centre de la structure de 100°C après 6 minutes.

Cette élévation serait de 40°C seulement après 30 s de chauffe, temps suffisant pour braser les puces sur la structure.

La figure 4 qui est une vue de dessus du dispositif ne représente plus l'écran thermique 160 pour des raisons de clarté.

La figure 4 laisse apparaître une partie saillante 104 de la plaque de chauffage en forme d'équerre. Des plages de transmission de chaleur 106 et 106' sont en contact avec des régions de connexion 114 et 114' situées sur le support de connexion 112, en bordure de la paroi 110.

Comme le montre la figure 4 où quatre puces colonnes 118 et deux puces lignes 118' sont reportées sur la lame inférieure 112 formant le support de connexion de l'écran plat 108, les plages 106 et 106' présentent respectivement des largeurs l et l' supérieures à la largeur des puces correspondantes, avec des bords 172, 172' pratiquement à l'aplomb du bord des puces. Les longueurs L et L' des plages 106 et 106' sont également légèrement supérieures à la longueur totale des puces assemblées.

A titre d'exemple pour un support 112 de 5x3,5 cm² avec quatre puces colonnes 118 de 6x10 mm² et deux puces lignes 118' de 3x10 mm² les dimensions des plages 106 et 106' sont respectivement de 8x44 mm² et 4,5x23 mm² approximativement.

La figure 4 représente la connexion des puces sur la même face de l'écran. Cependant, l'invention peut s'appliquer également à la connexion de puces de part et d'autre d'un même écran respectivement sur chacune de ces parois (110, 112) avec un ou des dispositifs de chauffage appropriés, dédiés au chauffage localisé des régions de connexion correspondantes.

Ceci est rendu possible du fait de la connexion par chauffage localisé, appliqué de part et d'autre de l'écran. Au contraire, les techniques de chauffage global utilisées dans l'art antérieur ne pouvaient effectuer les connexions que sur un seul côté de l'écran pour éviter la désolidarisation des connexions disposées sous l'écran.

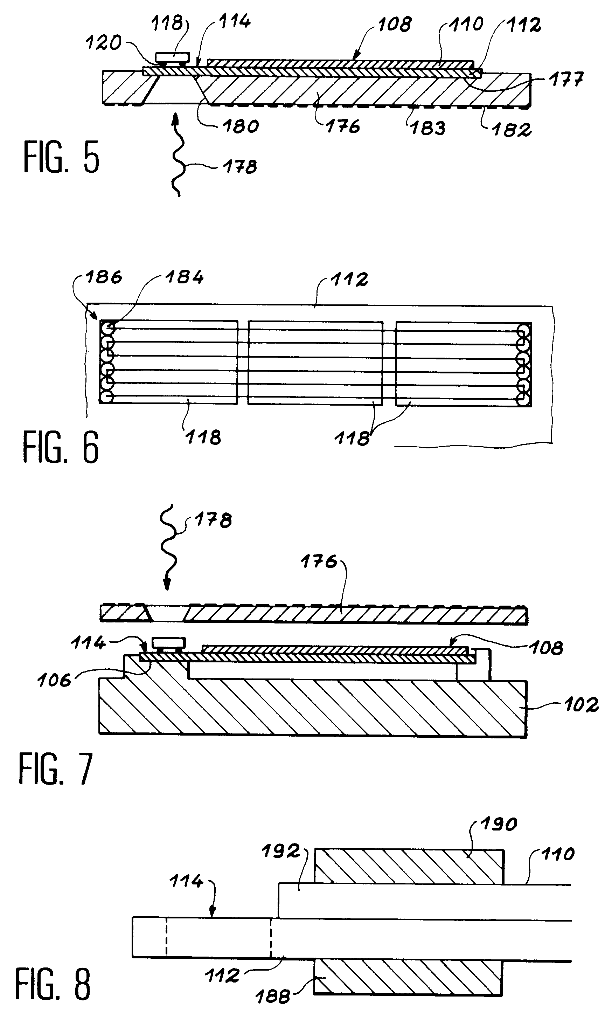

La figure 5 montre un dispositif selon une autre variante de l'invention.

Un écran plat 108 avec une paroi 110 et un support de connexion 112, similaires à l'écran 108 de la figure 2 précédente, est placé sur une plaque de protection thermique 176 située entre l'écran 108 et une source de rayonnement figurée par la flèche 178, telle qu'une lampe à infrarouge non représentée. La plaque de protection thermique 176 comporte une face de support 177 sur laquelle repose le support de connexion. Cette face est opposée à la face 182 tournée vers la source de rayonnement 178.

Cette plaque supporte l'écran lorsqu'elle a pour rôle également le maintien de l'écran. Mais dans le cas contraire, elle peut être positionnée à proximité de celle-ci.

Une ou plusieurs fenêtres 180 de passage du rayonnement pratiquées dans la plaque 176 permettent d'insoler la ou les régions de connexion 114 de l'écran 108 et de chauffer le matériau fusible des billes de connexion 120 du ou des composants 118 reportés dans la région 114.

Dans cet exemple, le support de connexion est exposé au rayonnement dans la région de connexion. Il est évident que le rayonnement peut aussi être dirigé vers les composants ou puces 118. Dans ce cas, la plaque 176 est située de l'autre côté de l'écran 108.

Les fenêtres 180 aménagées pour laisser passer le rayonnement ont une ouverture légèrement supérieure à la surface des composants à connecter. Leurs largeurs sont légèrement supérieures à la largeur des puces et leurs longueurs sont légèrement supérieures à la longueur totale des puces assemblées. A titre d'exemple, pour des puces et pour un écran du type mentionné précédemment, la largeur des fenêtres est respectivement de 6,2 mm et de 3,2 mm pour les puces colonnes et les puces lignes. Les longueurs respectives sont de 42 mm et 21 mm.

La plaque 176 par exemple en Inox présente avantageusement sur sa face 182 tournée vers la source de rayonnement 178 un revêtement 183 en un matériau tel que de l'or très réfléchissant aux longueurs d'ondes utilisées, pour éviter un chauffage important des parties écrantées de l'écran d'affichage 108. La plaque 176 peut également être réalisées entièrement en matériau réfléchissant.

Lorsque la plaque 176 présente une épaisseur supérieure ou égale à 5 mm, il peut être intéressant d'évaser les fenêtres 180 en augmentant leur dimension en regard de la source de rayonnement pour augmenter le flux lumineux chauffant.

La source de rayonnement 178 comprend par exemple une ou plusieurs sources lumineuses telles que des lampes halogènes émettant de préférence dans l'infrarouge.

Selon un autre mode de réalisation de l'invention, le dispositif de chauffage comporte au moins une source laser.

Le chauffage s'effectue alors sans plaque de protection, par balayage d'un faisceau laser sur les puces. Le chauffage peut avoir lieu à travers ou non le support 112.

La figure 6 illustre un exemple de balayage du faisceau. Un faisceau 184 figuré par un point, se déplace dans le sens de la longueur sur toutes les puces "colonnes" 118 ou "lignes" 118' en partant d'un coin 186 d'une puce d'extrémité.

Arrivé au coin opposé, le faisceau se déplace, par exemple, d'un diamètre du faisceau suivant l'axe perpendiculaire au balayage et retourne parallèlement au premier balayage sur la première puce et ainsi de suite jusqu'à ce que toute la surface des puces soit balayée.

Le balayage complet peut être effectué plusieurs fois jusqu'à ce que la température désirée soit atteinte.

Ce balayage est effectué de manière connue, soit par déplacement du faisceau laser à l'aide de miroirs montés sur des galvanomètres ou à l'aide de tables permettant la translation du support à chauffer.

La figure 7 montre un dispositif selon l'invention qui cumule les éléments des deux précédentes variantes.

Un écran d'affichage plat 108 est disposé sur une plaque chauffante 102 similaire à celle de la figure 2 dont certains éléments ne sont pas représentés toutefois.

La région de connexion 114 de l'écran 108 est chauffée non seulement par conduction avec la plage de transmission de chaleur 106, mais encore par un rayonnement infrarouge représenté par une flèche 178.

Une plaque de protection thermique 176 est disposée entre la source de rayonnement et l'écran plat 108. On peut noter que dans ce cas, c'est la face de l'écran présentant les composants ou les puces 118 qui est tournée vers le rayonnement 178.

Pour un écran à cristal liquide particulièrement sensible, une configuration telle que représentée à la figure 8 peut s'avérer nécessaire.

Deux doigts thermiques 188, 190 qui peuvent être similaires au doigt 150 de la figure 2 sont mis en contact respectivement directement sur les parois de l'écran 108.

Les doigts thermiques sont avantageusement en contact avec l'écran, en particulier au voisinage de la région de connexion 114.

Grâce à l'invention, il est possible de réaliser efficacement et rapidement des reports de composants sur des supports de connexion, même si ces derniers comportent des régions sensibles à la chaleur.

Par ailleurs, la description donne à titre illustratif l'application de l'invention à un écran plat, mais bien entendu, le support de connexion peut être différent d'une paroi d'écran.

### REFERENCES

**Document (1)****:**
   "Packaging Technology for Liquid Crystal Display" de Kohei Adachi, Solid State Technology, January 1993, pp. 63 à 71.
**Document (2)****:**
   "A Fine Pitch COG Technique for a TFT-LCD Panel Using an Indium Alloy" de Miki Mori et Al., Proceedings ECTC 1993.
**Document (3)****:**
   "Microelectronics Packaging Handbook", de Rao R. Tummala et E.J. Rymaszewski, January 1993, Van Nostrand Reinhold Book, pp.366 à 373.
**Document (4)****:**
   "Resin and Flexible Metal Bumps for Chip-on-Glass Technology, de Koji Matsui et al., Proceedings ECTC, 1993.

## Revendications

1. Dispositif de chauffage pour connecter, par l'intermédiaire d'un matériau fusible, sur un support de connexion (112), au moins un composant (118) reporté sur le support dans au moins une région de connexion (114) à la périphérie du support, caractérisé en ce que le dispositif comporte des moyens de chauffage localisé du support (112) et/ou du composant (118) dans la région de connexion, les moyens de chauffage comportant une plaque de chauffage (102) présentant au moins une plage (106) de transmission de chaleur par conduction au support de connexion (112) dans la région de connexion (114), la plage de transmission (106) étant ménagée sur une partie saillante (104) de la plaque, faisant saillie sur une partie sensiblement plane (122), tournée vers le support de connexion, de manière à préserver une couche d'air (158) de protection thermique entre la partie sensiblement plane (122) de la plaque et le support, en dehors de la région de connexion.

2. Dispositif selon la revendication 1, caractérisé en ce que le dispositif comprend en outre un écran thermique (160) disposé dans la couche d'air (122).

3. Dispositif selon la revendication 2, caractérisé en ce que l'écran thermique (160) présente une canalisation intérieure (162) de circulation d'un fluide de refroidissement.

4. Dispositif selon l'une des revendications 1 à 3 précédentes, caractérisé en ce qu'il comporte en outre des moyens de maintien (124) du support de connexion pour assurer un contact plan entre ledit support et la plage de transmission.

5. Dispositif selon la revendication 1, caractérisé en ce que le dispositif comprend en outre des moyens de positionnement du support sur la plage de transmission.

6. Dispositif selon la revendication 1, caractérisé en ce qu'il comporte un dispositif d'aspiration (146) débouchant dans la plage (106) de transmission de chaleur pour appliquer fermement le support de connexion (112) contre la plage de transmission de chaleur (106).

7. Dispositif selon l'une des revendications précédentes, caractérisé en ce que les moyens de chauffage localisé comportent au moins une source de rayonnement (178).

8. Dispositif selon la revendication 7, caractérisé en ce qu'il comprend en outre un écran thermique formé par une plaque de protection (176) disposée entre la source et le support avec une fenêtre (180) de passage du rayonnement pratiquée dans la plaque en face de la région de connexion.

9. Dispositif selon la revendication 8, caractérisé en ce que la plaque de protection présente sur une face (182) tournée vers la source (178) une surface réfléchissante (183).

10. Dispositif selon la revendication 8, caractérisé en ce que la fenêtre (180) présente une ouverture supérieure ou égale à la surface du composant (118).

11. Dispositif selon l'une quelconque des revendications 7 à 10, caractérisé en ce que la source de rayonnement (178) comporte au moins une lampe à infrarouge.

12. Dispositif selon l'une quelconque des revendications 7 à 11, caractérisé en ce que la source de rayonnement est dirigée vers le support de connexion et/ou vers le composant dans la région de connexion.

13. Dispositif selon l'une des revendications 7 à 10, caractérisé en ce que la source de rayonnement comporte au moins une source laser.

14. Dispositif selon la revendication 13, caractérisé en ce que la source laser est adaptée à émettre un faisceau (184) vers la région de connexion (114) et comporte des moyens pour balayer la région de connexion avec le faisceau.

15. Dispositif selon l'une quelconque des revendications précédentes, caractérisé en ce que le support de connexion est une lame de verre et le composant reporté est une puce électronique.

16. Dispositif selon l'une quelconque des revendications précédentes, caractérisé en ce que le support de connexion forme une paroi d'un écran plat d'affichage.

17. Dispositif selon l'une quelconque des revendications précédentes, caractérisé en ce qu'il comporte en outre au moins un doigt (150) de refroidissement en contact thermique direct ou indirect avec le support (112), à proximité de la région de connexion (114).
